# EUROPEAN PATENT APPLICATION

(11) **EP 4 692 273 A1**
(43) Date of publication of application: **11.02.2026**
(21) Application number: 24779769.9
(22) Date of filing: 19.03.2024
(51) Int. Cl.: C09K 3/10, C08K 5/14, C08L 29/10, C08L 83/04, H01L 21/3065

(54) **SEALING MATERIAL COMPOSITION AND SEALING MATERIAL**

(30) Priority: 29.03.2023 JP 2023053915
(71) Applicant: VALQUA, Ltd., Shinagawa-ku Tokyo 141-6024 (JP)
(72) Inventor: MOCHIZUKI, Tomomitsu, Gojo-shi, Nara 637-0014 (JP); OKAZAKI, Masanori, Gojo-shi, Nara 637-0014 (JP)
(74) Representative: Vossius & Partner Patentanwälte Rechtsanwälte mbB
(86) International application number: PCT/JP2024/010819
(87) International publication number: WO 2024/203645

(57) **Abstract**

The present disclosure relates to a sealing material composition with plasma resistance for use in semiconductor manufacturing equipment, a sealing material, a gate seal for semiconductor manufacturing equipment, and semiconductor manufacturing equipment, wherein the sealing material composition includes a silicone polymer and a vulcanizing agent, the silicone polymer containing a polysiloxane-based compound having an unsubstituted or substituted aromatic monovalent hydrocarbon group in a side chain. According to the present disclosure, provided is a sealing material composition, which can be used in low-temperature environments and has plasma resistance, and from which a sealing material for semiconductor manufacturing equipment can be produced by using relatively inexpensive materials.

## Description

### TECHNICAL FIELD

The present invention relates to a sealing material composition, and further relates to a sealing material, and general sealing materials including a gate seal for semiconductor manufacturing equipment containing the same, and also to semiconductor manufacturing equipment.

### BACKGROUND ART

Japanese Patent Laying-Open No. 2001-002923 (PTL 1) and Japanese Patent Laying-Open No. 2018-016795 (PTL 2) propose a fluorosilicone rubber composition and a perfluoroelastomer composition, respectively, for use as sealing materials.

### CITATION LIST

### PATENT LITERATURE

PTL 1: Japanese Patent Laying-Open No. 2001-002923
PTL 2: Japanese Patent Laying-Open No. 2018-016795

### SUMMARY OF INVENTION

### TECHNICAL PROBLEM

A low-temperature etching process in a low-temperature environment has been confirmed as an effective way to achieve miniaturization and high integration of circuits in a semiconductor field. Silicone rubber and fluorosilicone rubber are commonly used as sealing materials in low-temperature environments. However, silicone rubber, which is commonly used as a sealing material, has a usable temperature down to about -45°C, and even fluorosilicone rubber, which has relatively good low-temperature properties, can only be used down to -65°C, and these low-temperature properties are not enough. Therefore, a sealing material that can be used in a lower temperature environment (e.g., -70 to -100°C) is required.

On the other hand, in environments where plasma is used, perfluoroelastomers with plasma resistance are often used as sealing materials. However, perfluoroelastomers are very expensive and have relatively poor low-temperature properties, making them difficult to use in low-temperature environments.

An object of the present invention is to provide a sealing material composition, which can be used in low-temperature environments and has plasma resistance, and from which a sealing material for semiconductor manufacturing equipment can be produced by using relatively inexpensive materials. Another object of the present invention is to provide a sealing material composition including a silicone polymer, which has a relatively low glass transition temperature and a suppressed decrease in a weight loss rate in a plasma resistance test, and from which a sealing material for semiconductor manufacturing equipment can be produced.

### SOLUTION TO PROBLEM

The present invention provides a sealing material composition, a sealing material, a gate seal for semiconductor manufacturing equipment, and semiconductor manufacturing equipment as follows.
[1] A sealing material composition with plasma resistance for use in semiconductor manufacturing equipment including a silicone polymer and a vulcanizing agent, the silicone polymer containing a polysiloxane-based compound having an unsubstituted or substituted aromatic monovalent hydrocarbon group in a side chain.
[2] The sealing material composition according to [1], wherein the polysiloxane-based compound contains a constituent unit represented by the following formula (1): 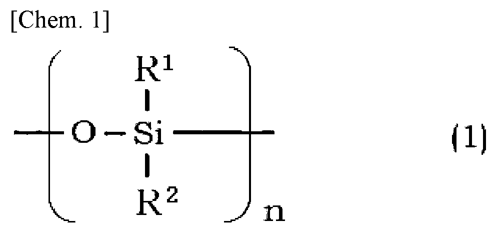 wherein
   R¹ independently represents an unsubstituted or substituted aromatic monovalent hydrocarbon group;
   R² independently represents an unsubstituted or substituted aromatic monovalent hydrocarbon group, an unsubstituted or substituted unsaturated or saturated hydrocarbon group not containing an aromatic hydrocarbon group, an alkoxy group a hydroxy group, or a hydrogen atom; and
   n represents an integer of 1 to 7000.
[3] The sealing material composition according to [2], wherein a ratio of the constituent unit represented by the formula (1) in the polysiloxane-based compound is 1 to 70 mol%.
[4] The sealing material composition according to any one of [1] to [3], wherein the polysiloxane-based compound has a group represented by (R³)₃Si-R⁴- at a main chain end, wherein each R³ independently represents an unsubstituted or substituted aromatic monovalent hydrocarbon group, an unsubstituted or substituted unsaturated or saturated hydrocarbon group not containing an aromatic hydrocarbon group, an alkoxy group, or a hydroxy group; and R⁴ independently represents an oxygen atom or an alkylene group having 1 to 5 carbon atoms.
[5] The sealing material composition according to any one of [1] to [4], wherein the polysiloxane-based compound contains a constituent unit represented by the following formula (2): 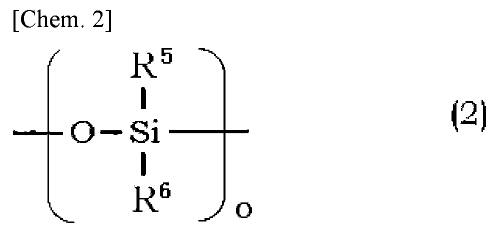 wherein
   R⁵ and R⁶ independently represent an unsubstituted or substituted unsaturated or saturated hydrocarbon group not containing an aromatic hydrocarbon group, an alkoxy group, or a hydroxy group; and
   o represents an integer of 100 to 10000.
[6] The sealing material composition according to any one of [1] to [5], wherein the polysiloxane-based compound has a vinyl group in at least one of a side chain and a main chain end.
[7] The sealing material composition according to any one of [1] to [6], further including at least one of 1 to 160 parts by mass of a filler and 0.05 to 3 parts by mass of a pigment based on 100 parts by mass of the silicone polymer.
[8] The sealing material composition according to any one of [1] to [7], wherein the vulcanizing agent contains a peroxide-based compound.
[9] The sealing material composition according to any one of [1] to [8], wherein a content of the vulcanizing agent is 0.2 to 8 parts by mass based on 100 parts by mass of the silicone polymer.
[10] The sealing material composition according to any one of [1] to [9], further including a perfluoropolyether-based compound.
[11] The sealing material composition according to any one of [1] to [10], wherein a metal ion content is 1000 ppm or less.
[12] A sealing material including a crosslinked product of the sealing material composition according to any one of [1] to [11].
[13] A gate seal for semiconductor manufacturing equipment including the sealing material according to [12].
[14] Semiconductor manufacturing equipment including the sealing material according to [12].

### ADVANTAGEOUS EFFECTS OF INVENTION

According to the present invention, provided can be a sealing material composition, which can be used in low-temperature environments and has superior plasma resistance, and from which a sealing material for semiconductor manufacturing equipment can be provided by using relatively inexpensive materials. According to the present invention, provided can be a sealing material composition containing a silicone polymer, which has a relatively low glass transition temperature and suppressed decrease in a weight loss rate in a plasma resistance test, and from which a sealing material for semiconductor manufacturing equipment can be produced.

### DESCRIPTION OF EMBODIMENTS

Hereinafter, embodiments of the present invention will be described, but the present invention will not be limited to the following embodiments.

### <Sealing Material Composition>

A sealing material composition according to an aspect of the present invention is a sealing material composition with plasma resistance for use in semiconductor manufacturing equipment. The sealing material composition includes a silicone polymer and a vulcanizing agent. The silicone polymer contains a polysiloxane-based compound having an unsubstituted or substituted aromatic monovalent hydrocarbon group in a side chain (hereinafter also referred to as a first polysiloxane-based compound). Although the first polysiloxane-based compound is a relatively inexpensive material, the present inventors have found that a sealing material composition with low-temperature properties and plasma resistance can be obtained. In the present description, the plasma resistance means that a weight loss rate (%) in the plasma resistance test described later is 1.0% or less. By using the sealing material composition of the present invention, it is possible to produce a sealing material with plasma resistance equal to or superior to that of a sealing material composition containing perfluoroelastomer. In addition, by using the sealing material composition of the present invention, it is possible to produce a sealing material having a weight loss rate equal to or less than that of a sealing material composition containing perfluoroelastomer in the plasma resistance test described later.

The first polysiloxane-based compound may have one or more of unsubstituted or substituted aromatic monovalent hydrocarbon groups bonded to Si atoms constituting a main chain. In the present description, the polysiloxane-based compound is a compound having a backbone (main chain) formed by a plurality of siloxane bonds (-Si-O-Si-) in a row.

Examples of the unsubstituted aromatic monovalent hydrocarbon group include: aryl groups such as a phenyl group and a tolyl group; aralkyl groups such as a benzyl group and a phenylethyl group; and the like. The substituted aromatic monovalent hydrocarbon group may be an aromatic monovalent hydrocarbon group in which some or all of the hydrogen atoms of the group exemplified as the above unsubstituted aromatic monovalent hydrocarbon group are substituted with halogen atoms such as fluorine and chlorine, and examples include a chlorophenyl group. From the viewpoint of low-temperature properties and plasma resistance, it is preferably the phenyl group. The first polysiloxane-based compound preferably has a diphenylsilyl group in which two phenyl groups are bonded to one Si atom constituting the main chain.

The first polysiloxane-based compound can contain a constituent unit (hereinafter also referred to as a first constituent unit) represented by the following formula (1): 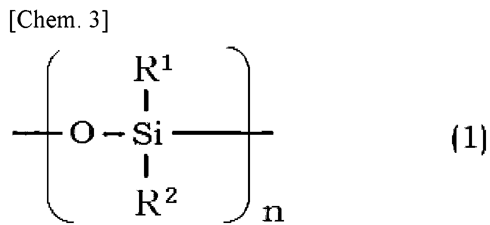 wherein
R¹ independently represents an unsubstituted or substituted aromatic monovalent hydrocarbon group;
R² independently represents an unsubstituted or substituted aromatic monovalent hydrocarbon group, an unsubstituted or substituted unsaturated or saturated hydrocarbon group not containing an aromatic hydrocarbon group, an alkoxy group, a hydroxy group, or a hydrogen atom; and
n represents an integer of 1 to 7000.

As examples of the unsubstituted or substituted aromatic monovalent hydrocarbon groups in R¹ and R², the examples described above are applied. Examples of the unsubstituted saturated hydrocarbon group not containing an aromatic hydrocarbon group in R² include alkyl groups such as a methyl group, an ethyl group, a propyl group, an isopropyl group, a butyl group, an isobutyl group, a tert-butyl group, a pentyl group, a hexyl group, a cyclohexyl group, an octyl group, a decyl group, and a dodecyl group. Examples of the unsubstituted unsaturated hydrocarbon group not containing an aromatic hydrocarbon group in R² include alkenyl groups such as a vinyl group, an allyl group, a propenyl group, an isopropenyl group, a butenyl group, and an isobutenyl group. R¹ is preferably a phenyl group from the viewpoint of low temperature properties and plasma resistance. The substituted unsaturated or saturated hydrocarbon group not containing an aromatic hydrocarbon group in R² may be a group in which some or all of the hydrogen atoms of the group exemplified as the above unsubstituted unsaturated or saturated hydrocarbon group not containing an aromatic hydrocarbon group are substituted with halogen atoms such as fluorine and chlorine, and examples include a chloromethyl group and a 3,3,3-trifluoropropyl group. Examples of the alkoxy group in R² include a methoxy group, an ethoxy group, a propoxy group, and a butoxy group. R¹ is preferably a phenyl group from the viewpoint of low-temperature properties and plasma resistance. R² is preferably a phenyl group from the viewpoint of low-temperature properties and plasma resistance.

A ratio of the first constituent unit in the first polysiloxane-based compound may be, for example, 1 to 70 mol%, and from the viewpoint of low-temperature properties and plasma resistance, is preferably 2 to 65 mol%, and more preferably 3 to 60 mol%.

The first polysiloxane-based compound may have a group represented by (R³)₃Si-R⁴- at a main chain end (hereinafter also referred to as an end group), wherein each R³ independently represents an unsubstituted or substituted aromatic monovalent hydrocarbon group, an unsubstituted or substituted unsaturated or saturated hydrocarbon group not containing an aromatic hydrocarbon group, an alkoxy group, or a hydroxy group; and R⁴ independently represents an oxygen atom or an alkylene group having 1 to 5 carbon atoms. As examples of the unsubstituted or substituted aromatic monovalent hydrocarbon group, the unsubstituted or substituted unsaturated or saturated hydrocarbon group not containing an aromatic hydrocarbon group, and the alkoxy group in R³, the examples described above are applied. Examples of the alkylene group having 1 to 5 carbon atoms in R⁴ include a methylene group, an ethylene group, and a propylene group. R³ is preferably a methyl group, a methoxy group, and a hydroxy group. R⁴ is preferably an oxygen atom and an ethylene group.

The first polysiloxane-based compound can contain a constituent unit (a second constituent unit) represented by the following formula (2): 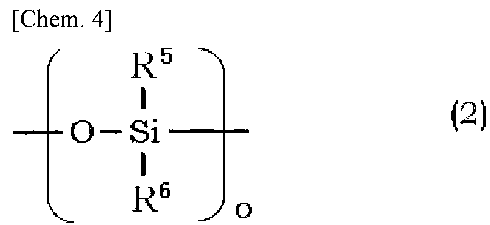 wherein
R⁵ and R⁶ independently represent an unsubstituted or substituted unsaturated or saturated hydrocarbon group not containing an aromatic hydrocarbon group, an alkoxy group, or a hydroxy group; and
o represents an integer of 100 to 10000.
A ratio of the second constituent unit in the first polysiloxane-based compound may be, for example, 30 to 99 mol%.

As examples of the unsubstituted or substituted unsaturated or saturated hydrocarbon group not containing an aromatic hydrocarbon group, and the alkoxy group in R⁵ and R⁶, the examples described above are applied. In the second constituent unit, at least one of R⁵ and R⁶ is preferably the unsubstituted unsaturated hydrocarbon group not containing an aromatic hydrocarbon group, and more preferably a vinyl group. When any one of R⁵ and R⁶ is an unsubstituted unsaturated hydrocarbon group not containing an aromatic hydrocarbon group, the other is preferably an unsubstituted saturated hydrocarbon group not containing an aromatic hydrocarbon group, and more preferably a methyl group.

The first polysiloxane-based compound preferably has a vinyl group in at least one of a side chain and a main chain end. When the first polysiloxane-based compound has the vinyl group in at least one of a side chain and a main chain end, the first polysiloxane-based compound may have one or two or more vinyl groups. When the first polysiloxane-based compound has the vinyl group in at least one of a side chain and a main chain end, a ratio of the constituent unit having the vinyl group in the first polysiloxane-based compound may be, for example, 0.001 to 10 mol%, and a lower limit of the ratio of the constituent unit may be, for example, 0.005 mol%, 0.01 mol%, 0.05 mol%, or 0.1 mol%, and an upper limit of the ratio of the constituent unit may be, for example, 8 mol%, 6 mol%, or 4 mol%.

The first polysiloxane-based compound is preferably a compound represented by the following formula (3): 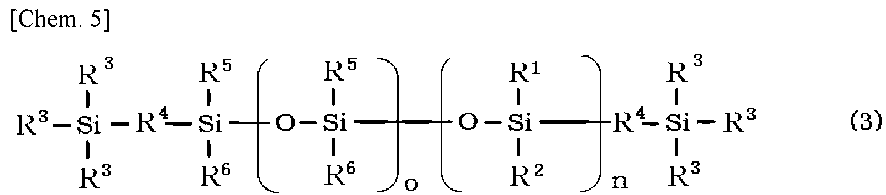 In formula (3), R¹, R², R³, R⁴, R⁵, R⁶, o, and n are as defined above.

The first polysiloxane-based compound is more preferably a compound represented by the following formula (4):

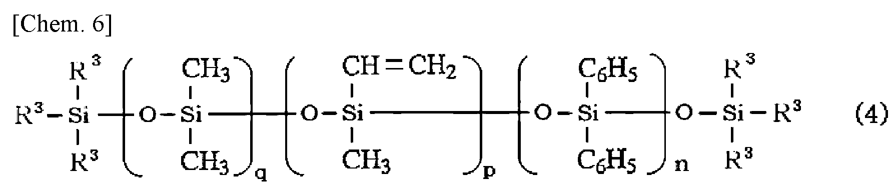

In formula (4), R³ and n are as defined above. p and q each independently represents an integer, and the total of p and q can be 100 to 10000. The total of p and q may be, for example, 1000 to 10000, 2000 to 10000, 3000 to 10000, or 5000 to 10000. The total of p, q, and n may be, for example, 1000 to 10000, 2000 to 10000, 3000 to 10000, or 5000 to 10000.

The first polysiloxane-based compound may be a copolymer containing the first constituent unit. The first polysiloxane-based compound can be obtained by copolymerizing a copolymerizable component containing the first constituent unit with another copolymerizable component (e.g., a copolymerizable component containing the second constituent unit, and the like). The compound represented by formula (4) can be obtained by copolymerizing, for example, a dimethylsiloxane-based copolymer component, a diphenylsiloxane-based copolymer component, and a methylvinylsiloxane-based copolymer component.

The first polysiloxane-based compound can be used in the form of a silicone rubber compound filled with silica, as described later. Examples of commercially available products include "KE-186-U", "KE-183-U", and "KE-136Y-U" produced by Shin-Etsu Chemical Co., Ltd., and "SE-955-U" produced by Dow Toray Co., Ltd.

The silicone polymer may contain one type or two or more types of the first polysiloxane-based compound. The silicone polymer may also contain a polysiloxane-based compound other than the first polysiloxane-based compound (hereinafter also referred to as a second polysiloxane-based compound). Examples of the second polysiloxane-based compound include dimethyl silicone, vinyl methyl silicone, and fluorovinyl methyl silicone. The silicone polymer preferably contains only the first polysiloxane-based compound. In addition, it is used as a blended rubber with other rubbers within a range that does not impair the object of the present invention.

As the vulcanizing agent, for example, a peroxide-based compound can be used. The peroxide-based compound is not particularly limited as long as it can be used for the silicone polymer, and examples include benzoyl peroxide, p-chlorobenzoyl peroxide, 2,4-dichlorobenzoyl peroxide, di-tert-butyl peroxide, tert-butylcumyl peroxide, dicumyl peroxide, 1,1-di(tert-butylperoxy)-3,3,5-trimethylcyclohexane, 2,5-dimethyl-2,5-di(tert-butylperoxy)hexane, 2,5-dimethyl-2,5-di(tert-butylperoxy)hexin-3, 1,3-di(tert-butylperoxyisopropyl)benzene, 2,5-dimethyl-2,5-di(benzoylperoxy)hexane, tert-butylperoxybenzoate, tert-butylperoxyisopropyl carbonate, and n-butyl-4,4-di(tert-butylperoxy)valerate. The vulcanizing agent may contain one type or two or more types of peroxide-based compounds.

A content of the vulcanizing agent in the sealing material composition may be, for example, 0.2 to 8 parts by mass based on 100 parts by mass of the silicone polymer, and is preferably 0.5 to 4 parts by mass.

The sealing material composition may further include a perfluoropolyether-based compound. The perfluoropolyether-based compound may be a low molecular weight compound such as an oligomer, or a high molecular weight compound such as a polymer. In particular, a perfluoropolyether-based polymer is preferably included from the viewpoint of low temperature properties and plasma resistance. The perfluoropolyether-based polymer may have a group capable of crosslinking reaction with the silicone polymer at a main chain end, for example. A commercially available perfluoropolyether-based polymer can be used. Examples of the commercially available perfluoropolyether-based polymer include SIFEL (R) (produced by Shin-Etsu Chemical Co., Ltd.). A content of the perfluoropolyether-based polymer in the sealing material composition may be, for example, 0.5 to 50 parts by mass based on 100 parts by mass of the silicone polymer, and is preferably 1 to 25 parts by mass.

The sealing material composition may include other components in addition to the above components, for example, additives such as a pigment, a filler, an anti-aging agent, an antioxidant, a vulcanization accelerator, a processing aid (such as stearic acid), a stabilizer, a tackifier, a silane coupling agent, a plasticizer, a flame retardant, a mold release agent, waxes, and a lubricant. Other examples of the additives include a stick-reducing (preventing) agent such as a fluorine-based oil (e.g., perfluoroether and the like). The additives may be used in one type only or in a combination of two or more types.

Examples of the pigment include at least one selected from the group consisting of an inorganic pigment and an organic pigment. Examples of the inorganic pigment include a white pigment (e.g., silica, zinc flower, lead white, lithopone, titanium dioxide, precipitated barium sulfate, and baryta powder), a red pigment (e.g., lead red and iron oxide red), a yellow pigment (e.g., lead yellow and zinc yellow), a blue pigment (e.g., ultramarine blue, Prussian blue, and YInMn blue), and a black pigment (e.g., carbon black). Examples of the organic pigment include an azo pigment (such as an azo lake pigment, an insoluble azo pigment, and a condensed azo pigment); a polycyclic pigment such as an anthraquinone-based pigment, a thioindigo-based pigment, a perinone-based pigment, a perylene-based pigment, a quinacridone-based pigment, an isoindolinone pigment, an isoindoline pigment, a dioxazine pigment, a quinophthalone pigment, and a diketopyrrolopyrrole pigment; and a phthalocyanine-based pigment. An organic pigment classified as a pigment in the color index may be used. Preferably an organic pigment containing no metal element is used. The organic pigment containing no metal element has no risk of scattering substances derived from the metal element, when the sealing material is used in harsh plasma environments and ozone environments such as semiconductor applications and even when an annular sealing material is etched. When the sealing material composition includes a pigment, a content of the pigment in the sealing material composition may be, for example, 0.05 to 3 parts by mass based on 100 parts by mass of the silicone polymer.

Examples of the filler include silica, quartz powder, clay, talc, diatomaceous earth, barium sulfate, mica, graphite, aluminum hydroxide, aluminum silicate, calcium silicate, hydrotalcite, calcium oxide, titanium oxide, zinc oxide, iron oxide, alumina, magnesium carbonate, calcium carbonate, zinc carbonate, carbon black, a granular or powdered resin (such as fluororesin), a metal powder, a glass powder, and a ceramic powder. When the sealing material composition includes a filler, it is advantageous from the viewpoint of improving the mechanical strength of the sealing material. The filler is preferably at least one selected from the group consisting of silica, carbon black and fluororesin.

Examples of the silica include fumed silica, precipitated silica, and fused silica. When the sealing material composition includes silica, a content of the silica in the sealing material composition may be, for example, 6 to 120 parts by mass based on 100 parts by mass of the silicone polymer. When the sealing material composition includes silica, a silicone rubber compound in which silica is blended into the silicone polymer may be used. As the silicone rubber compound, "KE-186-U" produced by Shin-Etsu Chemical Co., Ltd., "SE-955-U" produced by Dow Toray Co., Ltd., and the like can be also used as is. In addition, it is also used as a rubber blended with another rubber within a range that does not impair the object of the present invention.

Examples of the carbon black include MT carbon. Preferably, the sealing material composition does not contain a metallic filler from the viewpoint of filler scattering during use in semiconductor manufacturing equipment. When the sealing material composition includes carbon black, a content of the carbon black in the sealing material composition may be, for example, 1 to 30 parts by mass based on 100 parts by mass of the silicone polymer.

When the sealing material composition includes a filler of fluororesin, it tends to be advantageous in terms of improving plasma resistance. The fluororesin can be contained in the sealing material composition, for example, as fluororesin particles. When the sealing material composition includes the filler of fluororesin, a content of the filler of fluororesin in the sealing material composition may be, for example, 1 to 30 parts by mass based on 100 parts by mass of the silicone polymer, preferably 5 to 25 parts by mass, and more preferably 10 to 20 parts by mass.

The fluororesin used as a filler is a resin containing fluorine atoms in its molecule, and examples thereof can include polytetrafluoroethylene (PTFE), tetrafluoroethylene-perfluoroalkyl vinyl ether copolymer (PFA), tetrafluoroethylene-hexafluoropropylene copolymer (FEP), tetrafluoroethylene-ethylene copolymer (ETFE), polychlorotrifluoroethylene (PCTFE), chlorotrifluoroethylene-ethylene copolymer (ECTFE), polyvinylidene fluoride (PVDF), polyvinyl fluoride (PVF), vinylidene fluoride-hexafluoropropylene copolymer (VDF-HFP copolymer), and vinylidene fluoride-hexafluoropropylene-tetrafluoroethylene copolymer (VDF-HFP-TFE copolymer). The fluororesin can be used in one type only or in a combination of two or more types.

Among the above, from the viewpoint of preventing the resin from damaging the properties such as compression set by melting in high temperature environments, it is preferable to use fluororesins that have relatively high melting points, such as PFA and PTFE.

The fluororesin used as a filler may contain a functional group. The functional group can be introduced, for example, by copolymerizing monomers having the functional group. When the crosslinking site monomer described above is copolymerized as a monomer having a functional group, crosslinking between the fluororesin and the perfluoroelastomer also proceeds through the above crosslinking agent, and thereby it is possible to further increase the mechanical strength of a crosslinked product of the sealing material composition. Examples of the fluororesin containing a functional group can include a nitrile group-containing polytetrafluoroethylene described in Japanese Patent Laying-Open No. 2013-177631. In addition, the fluororesin may be a modified fluororesin, such as "TFM-modified PTFE" (produced by Dyneon Co., Ltd.).

When the sealing material composition includes a silicone polymer and a filler of fluororesin, as a method for kneading the silicone polymer and the fluororesin, for example, 1) a method for kneading the silicone polymer and the fluororesin using a mixing roll, or 2) a method for kneading the silicone polymer and the fluororesin using an apparatus such as a mixer and a twin-screw extruder, can be used.

When the sealing material composition includes a filler, a content of the filler in the sealing material composition (a total content in the case of including 2 or more types) may be, for example, 1 to 160 parts by mass based on 100 parts by mass of the silicone polymer, and is preferably 1 to 100 parts by mass, and more preferably 1 to 80 parts by mass.

A metal ion content of the sealing material composition may be, for example, 1000 ppm or less, 300 ppm or less, 100 ppm or less, or 50 ppm or less. The above range of the metal ion content of the sealing material composition allows the sealing material to be suitable for a sealing material used in semiconductor manufacturing equipment in which plasma treatment is performed.

The sealing material composition can be prepared by uniformly kneading a silicone polymer, a vulcanizing agent, and further a pigment, silica, and the like added as required. As kneading machines, conventionally known machines such as a mixing roll, a pressure kneader, and an internal mixer (Banbury mixer) can be used. Each blending component may be mixed and kneaded all at once, or may be kneaded in a plurality of stages such that components other than those contributing to a crosslinking reaction (a crosslinking accelerator, a crosslinking retarder, a crosslinking agent, or the like) are kneaded earlier and then the components contributing to the crosslinking reaction are kneaded.

The sealing material of the present invention includes a crosslinked product of the sealing composition described above. The sealing material can be produced by crosslinking (vulcanizing) and molding a rubber composition for the sealing material. As a method for crosslinking and molding, conventionally known methods such as injection molding, compression molding, and transfer molding can be adopted.

A heating temperature (primary crosslinking temperature) at a molding may be, for example, 100°C or more and 220°C or less, and a heating time (primary crosslinking time) may be, for example, 0.5 minutes or more and 120 minutes or less. After vulcanization molding, secondary crosslinking may be performed. A secondary crosslinking temperature may be, for example, 120°C or more and 280°C or less, and a secondary crosslinking time may be, for example, 0.5 hours or more and 24 hours or less.

A usable temperature range of the sealing material may be, for example, -70°C to 150°C, and can be preferably -100°C to 200°C, and more preferably -130° to 230°C. In the present description, the usable temperature range of the sealing material can be evaluated by measuring a glass transition temperature described later in the Example columns.

Hardness of the sealing material (type A durometer hardness) can be, for example, about 25 to 90. The hardness of the sealing material within the above range is preferable in terms of ease of attachment to semiconductor manufacturing equipment and sealability.

The sealing material can have the weight loss rate (%) of, for example, 1.0% or less in the plasma resistance test. The plasma resistance test can be performed according to the method described later in the Example columns. The weight loss rate (%) of the sealing material in the plasma resistance test is preferably 0.8% or less, and more preferably 0.6% or less. The weight loss rate of the sealing material of the present invention can be equal to or less than that of a sealing material including a perfluoroelastomer in the plasma resistance test.

Another aspect of the present invention is a sealing material that includes a crosslinked product of the above sealing material composition. The sealing material of the present invention can be a sealing material for semiconductor manufacturing equipment, and in particular, since it has plasma resistance, it is suitable as a sealing material for fixed parts and moving parts of vacuum chambers in semiconductor manufacturing equipment where plasma treatment is performed. In addition, since the sealing material of the present invention has the plasma resistance equal to or superior to that of sealing materials containing a perfluoroelastomer, it is suitable for semiconductor manufacturing equipment in which the sealing materials containing a perfluoroelastomer are used. Examples of the type of usage of the sealing material include various sealing materials, such as rings, packings, and gaskets.

Another aspect of the present invention is semiconductor manufacturing equipment that includes the above sealing material. In the semiconductor manufacturing equipment of the present invention, for example, a liquid crystal panel manufacturing apparatus, a plasma panel manufacturing apparatus, a plasma display panel manufacturing apparatus, a plasma address liquid crystal panel manufacturing apparatus, an organic EL panel manufacturing apparatus, a field emission display panel manufacturing apparatus, a solar cell substrate manufacturing apparatus, and a semiconductor transport apparatus are included in addition to a semiconductor manufacturing apparatus.

### EXAMPLES

Hereinafter, the present invention will be described in more detail with reference to Examples. Unless otherwise indicated, "%" and "parts" in Examples refer to % by mass and parts by mass, respectively.

### <Examples 1 to 10 and Comparative Examples 1 to 5>

According to the following procedure, a sealing material composition was prepared and then a sealing material was produced. First, according to the blending compositions shown in Table 1 (the unit of the blending amounts in Table 1 is parts by mass), predetermined amounts of each compounding agent were kneaded using an open roll. Then, the resulting sealing material composition was press-molded under a condition of 120°C for 20 minutes, and then subjected to secondary crosslinking by heat under a condition of 200°C for 4 hours to obtain a sealing material.

**[Table 1]**

| | | Examples | | | | | | | | | |
|---|---|---|---|---|---|---|---|---|---|---|---|
| | | 1 | 2 | 3 | 4 | 5 | 6 | 7 | 8 | 9 | 10 |
| PVMQ1 | | 100 | 100 | 100 | | | | 100 | 100 | 100 | 100 |
| PVMQ2 | | | | | 100 | | | | | | |
| PVMQ3 | | | | | | 100 | | | | | |
| PVMQ4 | | | | | | | 100 | | | | |
| Crosslinking agent 1 | | 0.7 | 0.7 | | 0.7 | 0.7 | | 0.7 | 0.7 | 0.7 | 0.7 |
| Crosslinking agent 2 | | | | | | | 1.5 | | | | |
| Crosslinking agent 3 | | | | 0.5 | | | | | | | |
| Filler 1 (Fluororesin) | | | | | | | | 10 | 20 | | |
| Additive 1 | | | | | | | | | | 2 | 10 |
| Additive 2 | | | | | | | | | | 2 | 10 |
| Pigment 1 | | | 0.13 | | | | | 0.13 | 0.13 | 0.13 | 0.13 |
| Glass transition temperature | (°C) | -114 | -117 | -113 | -113 | -117 | -115 | - | - | - | - |
| Plasma resistance | Weight loss rate (%) | 0.55 | 0.55 | 0.54 | 0.57 | 0.51 | 0.51 | 0.50 | 0.46 | 0.52 | 0.50 |
| Metal content | (ppm) | - | 21 | - | - | - | - | - | - | - | - |
| Normal state physical properties | Hardness | 61 | 65 | 63 | 38 | 50 | 50 | 64 | 65 | 63 | 55 |
| | Tensile strength (MPa) | 10.4 | 12.1 | 10.3 | 8.7 | 8.1 | 7.6 | 8.2 | 7.1 | 10.1 | 8.0 |
| | Elongation (%) | 650 | 675 | 475 | 750 | 575 | 425 | 520 | 480 | 610 | 580 |
| | 100% modulus (MPa) | 1.2 | 1.3 | 1.8 | 0.6 | 1.0 | 1.5 | 1.3 | 1.4 | 1.2 | 1.0 |

### Details of the blending components in Table 1 are as follows.

PVMQ1: phenylvinylmethylsilicone, "KE-186-U", Shin-Etsu Chemical Co., Ltd.
PVMQ2: phenylvinylmethylsilicone, "KE-183-U", Shin-Etsu Chemical Co., Ltd.
PVMQ3: phenylvinylmethylsilicone, "KE-136Y-U", Shin-Etsu Chemical Co., Ltd.
PVMQ4: phenylvinylmethylsilicone, "SE-955-U", Dow Toray Co., Ltd.
Crosslinking agent 1: para-methylbenzoyl peroxide, "C-23N", Shin-Etsu Chemical Co., Ltd.
Crosslinking agent 2: bis(4-methylbenzoyl)peroxide, "RC14", Dow Toray Co., Ltd.
Crosslinking agent 3: 2,5-dimethyl-2,5-bis(t-butylperoxy)hexane, "C-8A", Shin-Etsu Chemical Co., Ltd.
Filler 1: PTFE, "LUBRON L5", DAIKIN INDUSTRIES, LTD.
Additive 1: perfluoropolyether-based compound, "SIFEL8070A", Shin-Etsu Chemical Co., Ltd.
Additive 2: perfluoropolyether-based compound, "SIFEL8070B", Shin-Etsu Chemical Co., Ltd.
Pigment 1: "Violet #V4879", RESINO COLOR INDUSTRIES CO., LTD.

**[Table 2]**

| | | Comparative Examples | | | | |
|---|---|---|---|---|---|---|
| | | 1 | 2 | 3 | 4 | 5 |
| FVMQ | | | | 100 | | |
| VMQ1 | | | | | 100 | |
| VMQ2 | | | | | | 100 |
| FFKM | | 100 | | | | |
| FKM | | | 100 | | | |
| Crosslinking agent 4 | | | | 0.8 | 0.4 | |
| Crosslinking agent 5 | | | | | | 0.65 |
| Crosslinking agent 6 | | 1 | | | | |
| Acid acceptor 1 | | | 3 | | | |
| Acid acceptor 2 | | | 6 | | | |
| Filler 2 (Carbon black) | | | 20 | | | |
| Pigment 2 | | | | 1.5 | | |
| Pigment 3 | | | | | 1.5 | |
| Glass transition temperature | (°C) | 13 | -7 | -65 | - | -45 |
| Plasma resistance | Weight loss rate (%) | 0.57 | 11.2 | 1.24 | 1.82 | 1.23 |
| Metal content | (ppm) | 3 | 2,128 or more | 4,209 or more | 5,531 or more | 350 |
| Normal state physical properties | Hardness | 70 | 70 | 73 | 70 | 47 |
| | Tensile strength (MPa) | 13.0 | 14.0 | 7.8 | 6.0 | 7.9 |
| | Elongation (%) | 180 | 260 | 280 | 190 | 360 |
| | 100% modulus (MPa) | 3.0 | 5.0 | 3.6 | 3.4 | 1.5 |

### Details of the blending components in Table 2 are as follows.

FVMQ: fluorosilicone compound, "FE-271-U", Shin-Etsu Chemical Co., Ltd.
VMQ1: silicone rubber compound, "KE-971-U", Shin-Etsu Chemical Co., Ltd.
VMQ2: silicone rubber compound, "KE-951-U", Shin-Etsu Chemical Co., Ltd.
FFKM: perfluoroelastomer, "PFE191T", 3M.
FKM: fluororubber, "DAI-EL G783", DAIKIN INDUSTRIES, LTD.
Crosslinking agent 4: 2,5-dimethyl-2,5-bis(t-butylperoxy)hexane, "C-8A", Shin-Etsu Chemical Co., Ltd.
Crosslinking agent 5: benzoyl peroxide, "C1A", Shin-Etsu Chemical Co., Ltd.
Crosslinking agent 6: 2,2-bis(3-amino-4-hydroxyphenyl)hexafluoropropane, Tokyo Chemical Industry Co., Ltd.
Acid acceptor 1: magnesium oxide, "Kyowamag MA150", Kyowa Chemical Industry Co., Ltd.
Acid acceptor 2: calcium hydroxide, "CALDIC #2000", Ohmi Chemical Industry Co., Ltd.
Filler 2: MT carbon, "Thermax N990", Cancarb Limited.
Pigment 2: "Ferro Blue V-3285", Ferro Japan Co., Ltd.
Pigment 3: "KE-COLOR-BR", Shin-Etsu Chemical Co., Ltd.

### (Evaluation of Sealing Material)

On the resulting crosslinked molded products (sealing materials), the following evaluations were performed. The results are shown in Table 1.

### [1] Measurement of Glass Transition Temperature

The resulting molded products were measured by using a DVA-225 (produced by IT Measurement and Control Co., Ltd.) under a measurement temperature: -150 to 150°C, a temperature rising condition: 2°C/min, a frequency: 1 Hz, and a measurement mode: tensile in an air environment. A glass transition temperature was defined as the peak value of tan δ. The glass transition temperature is a temperature that is a standard for the low-temperature service range of a sealing material. The lower the glass transition temperature, the more advantageous the material is for use in low-temperature environments.

### [2] Plasma Resistance Test

The plasma resistance (weight loss rate) of the resulting molded products was measured. Specifically, the measurements were performed as follows.

Using a flat plasma treatment device with an electrode diameter of ϕ240 mm, the resulting molded products were exposed to plasma for 1 hour under the following conditions: RF: 250 W, a flow ratio of O₂ gas and CF₄ gas (O₂:CF₄): 180:20, a gas flow rate: 200 sccm, vacuum degree: 133 Pa.

Then, the weights of the molded products were measured before and after the test, and the weight loss rate (%) was calculated using the following formula to evaluate the plasma resistance. The lower weight loss rate indicates the better plasma resistance.

Weight Loss Rate (%) = [(Weight of Molded Product Before Test - Weight of Molded Product After Test) / Weight of Molded Product Before Test]×100

### [3] Measurement of Metal Ion Content

The resulting molded products were washed with dilute acid, followed by ashing treatment with nitric acid. After adding concentrated acid and heating to concentrate, dilute acid (recovery solution) was added, and the mixture was heated and recovered, and then transferred to a fluororesin container and subjected to qualitative analysis using 1CP mass spectrometry. Internal standard elements were previously added to the recovery solution. Measurements were performed using an ICP-MS Agilent 7500CS (produced by Agilent Technologies).

### [4] Measurement of Normal State Physical Properties

Hardness (type A durometer hardness) was measured in accordance with JIS K 6253:2012 using a type A durometer hardness tester. Tensile tests were performed in accordance with JIS K 6251 using a Shopper-type tensile testing machine with a specimen shape of No. 3 dumb-bell to measure tensile strength (MPa), elongation (%), and 100% modulus (MPa).

As shown in Table 1, in Examples 1 to 10, the glass transition temperature was much lower than that of Comparative Example 1 using FFKM, and the weight loss rate in the plasma resistance evaluation was lower than that of Comparative Examples 2 to 5 using silicone polymers not containing a phenyl group. From this, it can be understood that the present invention provides a sealing material composition that can be used in low-temperature environments and has plasma resistance, at low cost.

## Claims

1. A sealing material composition with plasma resistance for use in semiconductor manufacturing equipment comprising a silicone polymer and a vulcanizing agent,
the silicone polymer containing a polysiloxane-based compound having an unsubstituted or substituted aromatic monovalent hydrocarbon group in a side chain.

2. The sealing material composition according to claim 1, wherein the polysiloxane-based compound contains a constituent unit represented by the following formula (1): 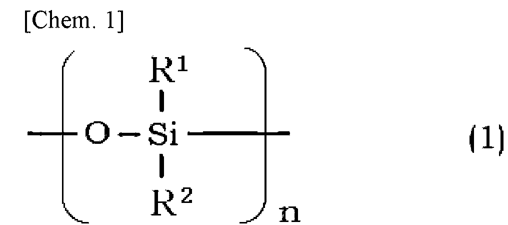 wherein
R¹ independently represents an unsubstituted or substituted aromatic monovalent hydrocarbon group;
R² independently represents an unsubstituted or substituted aromatic monovalent hydrocarbon group, an unsubstituted or substituted unsaturated or saturated hydrocarbon group not containing an aromatic hydrocarbon group, an alkoxy group, a hydroxy group, or a hydrogen atom; and
n represents an integer of 1 to 7000.

3. The sealing material composition according to claim 2, wherein a ratio of the constituent unit represented by the formula (1) in the polysiloxane-based compound is 1 to 70 mol%.

4. The sealing material composition according to claim 2, wherein the polysiloxane-based compound has a group represented by (R³)₃Si-R⁴- at a main chain end, wherein each R³ independently represents an unsubstituted or substituted aromatic monovalent hydrocarbon group, an unsubstituted or substituted unsaturated or saturated hydrocarbon group not containing an aromatic hydrocarbon group, an alkoxy group, or a hydroxy group; and R⁴ independently represents an oxygen atom or an alkylene group having 1 to 5 carbon atoms.

5. The sealing material composition according to claim 4, wherein the polysiloxane-based compound contains a constituent unit represented by the following formula (2): 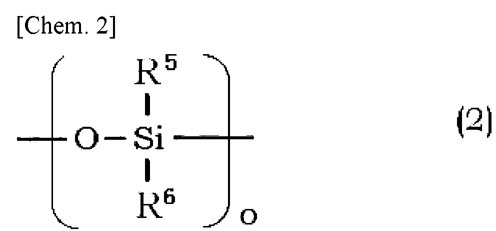 wherein
R⁵ and R⁶ independently represent an unsubstituted or substituted unsaturated or saturated hydrocarbon group not containing an aromatic hydrocarbon group, an alkoxy group, or a hydroxy group; and
o represents an integer of 100 to 10000.

6. The sealing material composition according to claim 5, wherein the polysiloxane-based compound has a vinyl group in at least one of a side chain and a main chain end.

7. The sealing material composition according to claim 1, further comprising at least one of 1 to 160 parts by mass of a filler and 0.05 to 3 parts by mass of a pigment based on 100 parts by mass of the silicone polymer.

8. The sealing material composition according to claim 1, wherein the vulcanizing agent contains a peroxide-based compound.

9. The sealing material composition according to claim 1, wherein a content of the vulcanizing agent is 0.2 to 8 parts by mass based on 100 parts by mass of the silicone polymer.

10. The sealing material composition according to claim 1, further comprising a perfluoropolyether-based compound.

11. The sealing material composition according to claim 1, wherein a metal ion content is 1000 ppm or less.

12. A sealing material comprising a crosslinked product of the sealing material composition according to claim 1.

13. A gate seal for semiconductor manufacturing equipment comprising the sealing material according to claim 12.

14. Semiconductor manufacturing equipment comprising the sealing material according to claim 12.
